# EUROPEAN PATENT APPLICATION

(11) **EP 4 432 330 A1**
(43) Date of publication of application: **18.09.2024**
(21) Application number: 22895437.6
(22) Date of filing: 02.11.2022
(51) Int. Cl.: H01L 21/02, H01L 21/60, H01L 21/677, H01L 21/67, H01L 21/673

(54) **PROCESSING SYSTEM, ELECTROSTATIC CARRIER, AND PROCESSING METHOD**

(30) Priority: 16.11.2021 JP 2021186685
(71) Applicant: Tokyo Electron Limited, Tokyo 107-6325 (JP)
(72) Inventor: HAYAKAWA, Susumu, Kikuchi-gun, Kumamoto 869-1232 (JP); MIZOMOTO, Yasutaka, Kikuchi-gun, Kumamoto 869-1232 (JP)
(74) Representative: Manitz Finsterwald Patent- und Rechtsanwaltspartnerschaft mbB
(86) International application number: PCT/JP2022/040976
(87) International publication number: WO 2023/090155

(57) **Abstract**

A processing system configured to process multiple chips includes a chip placing apparatus configured to pick the chip up and dispose on an attraction surface of a first electrostatic carrier. The chip placing apparatus includes a placement carrier holder configured to hold the first electrostatic carrier; and a power supply configured to apply a voltage to the first electrostatic carrier held by the placement carrier holder.

## Description

### TECHNICAL FIELD

The various aspects and embodiments described herein pertain generally to a processing system, an electrostatic carrier, and a processing method.

### BACKGROUND

Patent Document 1 discloses a chip-on-wafer (CoW) bonding method for mounting a chip on a wafer. In this chip-on-wafer bonding method, before a plurality of chips are finally bonded on corresponding bonding portions of a substrate, a surface activation treatment and a hydrophilization treatment are performed on bonding surfaces of the chips, and the plurality of chips are preliminarily bonded on the substrate through water. The water once applied to the bonding surfaces is all removed by heating in the final bonding.

Patent Document 2 discloses a reinforcing member for a thin plate material such as a silicon wafer. This reinforcing member has a reinforcing member main body provided with a thin plate-shaped electrostatic holder in which an electrode is embedded inside an electrical insulating layer. Then, by applying a high voltage to the electrode and supplying the reinforcing member with electric charges whose polarity is opposite to that of the voltage applied to the electrode, an attracting force is exerted in the electrostatic holder to attract a target object to be reinforced, allowing the reinforming member main body to function as the reinforcing member.

### PRIOR ART DOCUMENT

Patent Document 1: Japanese Patent No. 6,337,400
Patent Document 2: Japanese Patent Laid-open Publication No. 2009-099674

### DISCLOSURE OF THE INVENTION

### PROBLEMS TO BE SOLVED BY THE INVENTION

Exemplary embodiments provide a technique enabling appropriate reduction of cost and time required for a chip-on-wafer manufacturing process.

### MEANS FOR SOLVING THE PROBLEMS

In an exemplary embodiment, a processing system configured to process multiple chips includes a chip placing apparatus configured to pick the chip up and dispose on an attraction surface of a first electrostatic carrier. The chip placing apparatus includes a placement carrier holder configured to hold the first electrostatic carrier; and a power supply configured to apply a voltage to the first electrostatic carrier held by the placement carrier holder.

### EFFECT OF THE INVENTION

According to the exemplary embodiments, it is possible to appropriately reduce cost and time required for the chip-on-wafer manufacturing process.

### BRIEF DESCRIPTION OF THE DRAWINGS

**FIG. 1** is an explanatory diagram schematically illustrating a structure of a chip attached to a dicing sheet.
**FIG. 2** is a cross sectional view schematically illustrating a structure of an electrostatic carrier according to an exemplary embodiment.
**FIG. 3** is a cross sectional view schematically illustrating a structure of a wafer to which the chip is to be bonded.
**FIG. 4** is a plan view schematically illustrating a configuration of a processing system according to the exemplary embodiment.
**FIG. 5** is a cross sectional view schematically illustrating a configuration of a chip placing apparatus.
**FIG. 6** is a cross sectional view schematically illustrating a transferring apparatus.
**FIG. 7** is a cross sectional view schematically illustrating a configuration of a bonding apparatus.
**FIG. 8** is a flowchart showing main processes of a chip-on-wafer manufacturing process according to the exemplary embodiment.
**FIG. 9A** to **FIG. 9F** are explanatory side views showing some of the processes of the chip-on-wafer manufacturing process according to the exemplary embodiment.
**FIG. 10A** to **FIG. 10F** are explanatory side views showing some of the processes of the chip-on-wafer manufacturing process according to the exemplary embodiment.
**FIG. 11** is a cross sectional view schematically illustrating a structure of an electrostatic carrier according to another exemplary embodiment.

### DETAILED DESCRIPTION

Recently, in a manufacturing process for semiconductor devices, a chip-on-wafer (CoW) manufacturing process has been examined as one way of a 3D packaging technology to meet a demand for higher performance and higher density of devices. Manufacture of a chip-on wafer is carried out by a method described in Patent Document 1, for example.

However, in this chip-on-wafer manufacturing process, prior to final mounting of semiconductor chips (hereinafter, simply referred to as "chips") onto a semiconductor substrate (hereinafter, simply referred to as "wafer"), each of the chips needs to be temporarily placed on the wafer. In this temporary mounting of the chips, however, a series of treatments including surface activation and hydrophilization of a bonding surface of each of the plurality of chips are required, as described in Patent Document 1. In this regard, there is a room for improvement from the viewpoint of cost and the number of processes involved.

The inventors of the present application have conducted intensive research and found out that it is possible to significantly reduce the cost and the number of processes required for the chip-on-wafer manufacturing process by applying an electrostatic holding mechanism. Specifically, instead of temporarily bonding the plurality of chips on the wafer in the chip-on-wafer manufacturing process, a carrier substrate having an attracting/holding function by an electrostatic (Coulomb) force (hereinafter referred to as "electrostatic carrier (ESW: Electro Static Carrier Wafer)") is employed to attract and hold the plurality of chips on the electrostatic carrier.

Although Patent Document 2 discloses the electrostatic reinforcing device for holding and reinforcing the thin plate material such as a silicon wafer, it does not mention anything about the aforementioned inventive concept of holding the plurality of chips on the carrier wafer by electrostatic attraction and finally mounting the chips on a mounting target wafer.

In view of the foregoing, exemplary embodiments of the present disclosure provide a technique enabling appropriate reduction of cost and time required for the chip-on-wafer manufacturing process. Hereinafter, a processing system and a processing method according to the exemplary embodiment will be described with reference to the accompanying drawings. In the present specification and drawings, parts having substantially the same functions and configurations will be assigned same reference numerals, and redundant description thereof will be omitted.

In a processing system 10 according to the present exemplary embodiment, which will be described later, a plurality of chips C that are arranged and attached on an adhesive surface of a dicing tape T to be described later are disposed on an electrostatic carrier Cw to be described later, and the plurality of chips C on the electrostatic carrier Cw are bonded to a wafer W as a target on which the chips C are to be finally mounted (a chip-on-wafer manufacturing process). Hereinafter, in each of the plurality of chips C, a surface on which a device layer D to be described later is formed is referred to as a front surface Ca, and a surface opposite to the front surface Ca and attached to the dicing tape T is referred to as a rear surface Cb.

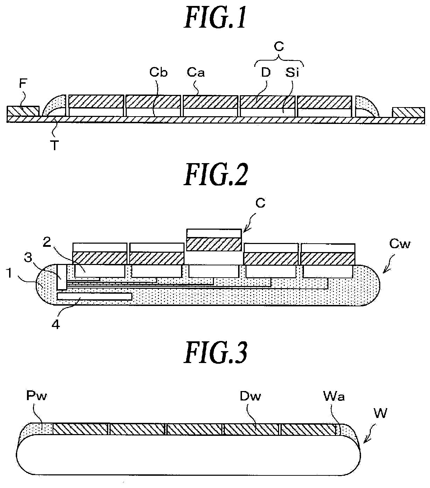

As shown in **FIG. 1****,** a silicon layer Si is formed on the rear surface Cb side of the chip C, and the device layer D including a plurality of devices is formed on the silicon layer Si. The rear surface Cb side of the chip C is attached to the dicing tape T as stated above. In other words, the device layer D of the chip C is attached to the dicing tape T with the silicon layer Si therebetween. Further, a non-illustrated protective film is formed on the front surface Ca side of the chip C to protect the device layer D in a series of chip-on-wafer manufacturing processes to be described later.

In addition, the dicing tape T is fixed to a dicing frame F as shown in **FIG. 1** during a transfer in the processing system 10 to be described later.

The electrostatic carrier Cw has, on a top surface thereof, an attraction surface for electrostatically attracting and holding the plurality of chips C. As illustrated in **FIG. 2****,** the electrostatic carrier Cw has, inside a main body 1 having electrical insulation property, a plurality of attraction electrodes 2, an attraction control terminal 3 configured to control the attraction and holding of the chips C by the attraction electrodes 2, and a capacitor 4 configured to accumulate electric charges therein by receiving a direct current (DC) voltage applied thereto.

The main body 1 has a circular plate shape substantially the same as the wafer W on which the chips C are to be mounted, and is made of a material, such as ceramic, having electrical insulation property as mentioned above.

Each attraction electrode 2 has a size corresponding to one chip C to be held thereon. Further, when viewed from the top (in a plan view), the attraction electrodes 2 are arranged inside the main body 1 within the attraction surface of the electrostatic carrier Cw so as to correspond to bonding positions of the chips C (mounting positions of the chips C) on a chip mounting surface of the wafer W.

The attraction control terminal 3 is disposed at the attraction surface side for the chips C within the main body 1. The attraction control terminal 3 is electrically connected to each of the plurality of attraction electrodes 2 within the main body 1, as illustrated in **FIG. 2****.**

Further, the attraction control terminal 3 is configured to be capable of communicating with a chip placing apparatus 60, a transferring apparatus 100, a bonding apparatus 140 or a control device 150 of the processing system 10 to be described later, and is also configured to be capable of applying an attraction voltage to each of the plurality of attraction electrodes 2 independently based on signals received from these apparatuses. In the electrostatic carrier Cw, the chip C can be attracted to and held on the attraction surface by a Coulomb force generated by applying the voltage to the attraction electrode 2 via the attraction control terminal 3 in this manner.

The capacitor 4, which serves as a power storage member, stores therein electric charges when a voltage is applied from the chip placing apparatus 60, the transferring apparatus 100, or the bonding apparatus140 of the processing system 10 to be described later. The electric charges accumulated inside the capacitor 4 are discharged toward each attraction electrode 2 via the aforementioned attraction control terminal 3 to be used for attraction/holding or separation of the chip C on the electrostatic carrier Cw.

The wafer W on which the chip C is to be mounted is a semiconductor wafer such as a silicon substrate or a glass substrate for use in a manufacturing process for a semiconductor device. As shown in **FIG. 3**, a device layer Dw including a plurality of devices is formed on a front surface Wa as a mounting surface on which the chip C is to be mounted.

The device layer Dw is divided into smaller sections each having approximately the same size as the chip C to be mounted, as shown in **FIG. 3****.** In other words, each of the smaller sections of the device layer Dw on the mounting surface of the wafer W becomes a bonding position (mounting position) of the chip C on the wafer W.

Further, a protective film Pw is formed on the front surface Wa of the wafer W, and the thickness of this protective film Pw is approximately equal to the thickness of the device layer Dw. In other words, on the front surface Wa side of the wafer W, there exist portions where the smaller sections of the device layer Dw are exposed and portions where the protective film Pw is exposed between these smaller sections of the device layer Dw.

The wafer W is bonded to the chip C in the bonding apparatus 140 of the processing system 10 to be described later. Before being carried into the bonding apparatus 140, various types of pre-treatments for the bonding are performed on the front surface Wa of the wafer W. More specifically, the front surface Wa of the wafer W to be carried into the processing system 10 is previously subjected to a series of pre-treatments including surface activation and hydrophilization in one or more pre-treatment apparatuses disposed outside the processing system 10.

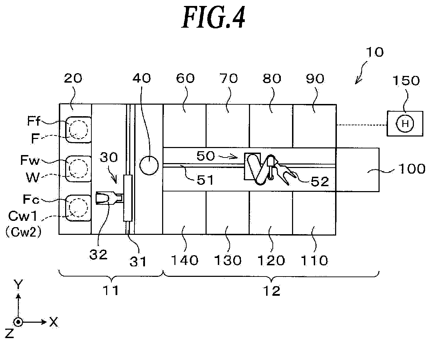

As depicted in **FIG. 4****,** the processing system 10 has a configuration in which a carry-in/out station 11 and a processing station 12 are connected as one body. In the carry-in/out station 11, FOUPs (Front Opening Unified Pods) Ff and Fw capable of accommodating therein a multiple number of dicing frames F and a multiple number of wafers W, respectively, and a FOUP Fc capable of accommodating therein a first electrostatic carrier Cw1 and a second electrostatic carrier Cw2 are carried to/from, for example, the outside. The processing station 12 is equipped with various types of processing apparatus configured to perform a series of chip-on-wafer manufacturing processes to be described later.

A FOUP placing table 20 is provided in the carry-in/out station 11. In the shown example, a plurality of, for example, three FOUPs Ff, Fw, and Fc are arranged on the FOUP placing table 20 in a row in the Y-axis direction. Further, the number and the layout of the FOUPs Ff, Fw, and Fc placed on the FOUP placing table 20 are not limited to the example of the present exemplary embodiment, but may be selected as required.

A transfer device 30 is provided adjacent to the FOUP placing table 20 on the positive X-axis side of the FOUP placing table 20. The transfer device 30 is configured to be movable on a transfer path 31 which is elongated in the Y-axis direction. Further, the transfer device 30 is equipped with, for example, two transfer arms 32 each of which is configured to hold and transfer the dicing frame F, the wafer W, and the electrostatic carrier Cw (hereinafter, these may be collectively referred to as "dicing frame F, *etc."*). Each transfer arm 32 is configured to be movable in a horizontal direction and a vertical direction and pivotable around a horizontal axis and a vertical axis. Further, the configuration of the transfer arm 32 is not limited to the exemplary embodiment, and various other configurations may be adopted. The transfer device 30 is configured to be capable of transferring the dicing frame F, *etc.,* to/from the FOUPs Ff, Fw, and Fc of the FOUP placing table 20 and a transition device 40 to be described later.

In the carry-in/out station 11, the transition device 40 configured to deliver the dicing frame F, *etc.,* to/from the processing station 12 is provided adjacent to the transfer device 30 on the positive X-axis side of the transfer device 30.

The processing station 12 is equipped with a transfer device 50, the chip placing apparatus 60, a protective film forming apparatus 70, a processing apparatus 80, a protective film removing apparatus 90, the transferring apparatus 100, a second protective film forming apparatus 110, a planarizing apparatus 120, a second protective film removing apparatus 130, and the bonding apparatus 140. Here, the number and the layout of these various types of processing apparatuses are not limited to the present exemplary embodiment but may be selected as required.

The transfer device 50 is disposed on the positive X-axis side of the transition device 40. The transfer device 50 is configured to be movable on a transfer path 51 which is elongated in the X-axis direction. Further, the transfer device 50 has, for example, two transfer arms 52 each of which is configured to hold and transfer the dicing frame F, *etc..* Each transfer arm 52 is configured to be movable in a horizontal direction and a vertical direction and pivotable around a horizontal axis and a vertical axis, and is configured to be capable of transferring the dicing frame F, *etc.,* to/from the transition device 40 of the carry-in/out station 11 and the various types of processing apparatuses of the processing station 12.

In the chip placing apparatus 60, the plurality of chips C attached on the dicing tape T are arranged and disposed on an attraction surface of the first electrostatic carrier Cw1, which serves as a relay member when mounting the chips C onto the wafer W.

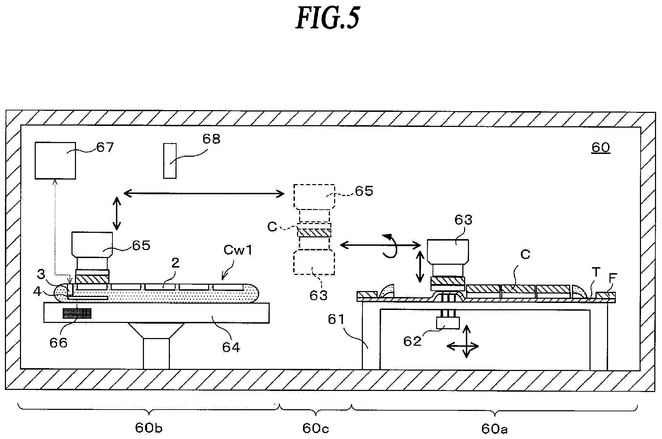

As illustrated in **FIG. 5****,** a pick-up area 60a, an arrangement area 60b, and a delivery area 60c are formed inside the chip placing apparatus 60. In the pick-up area 60a, the chips C are picked up from the dicing frame F. In the arrangement area 60b, the chips C are arranged in the first electrostatic carrier Cw1. In the delivery area 60c, the chips C are delivered between the pick-up area 60a and the arrangement area 60b.

The pick-up area 60a is provided with a first holder 61, a pusher 62, and a first collet 63.

The first holder 61 has a holding surface for the dicing frame F on a top surface thereof, and holds the dicing frame F transferred by the transfer device 50, allowing the plurality of chips C attached to the dicing tape T to face upwards.

The pusher 62 is disposed below the first holder 61, and configured to selectively push one of the plurality of chips C on the dicing tape T upwards from below to raise it.

The first collet 63 is disposed above the first holder 61, and is configured to hold the one chip C pushed up by the pusher 62 from above and transfer the held chip C between the pickup area 60a and the delivery area 60c. Additionally, in one example, the first collet 63 is configured to be rotated around a horizontal axis to invert top and bottom surfaces of the held chip C as in the shown example.

The arrangement area 60b is provided with a second holder 64, a second collet 65, a power supply 66, a communicator 67, and an alignment mechanism 68.

The second holder 64 as a placement carrier holder has a holding surface for the first electrostatic carrier Cw1 on a top surface thereof, and holds the first electrostatic carrier Cw1 transferred by the transfer device 50 such that the attraction surface of the first electrostatic carrier Cw1 for the chips C faces upwards.

The second collet 65 is disposed above the second holder 64, and is configured to hold the chip C held by the first collet 63 from above and transfer the held chip C between the arrangement area 60b and the delivery area 60c.

In one example, the power supply 66 is disposed inside the second holder 64, and is configured to apply a voltage to the first electrostatic carrier Cw1 on the second holder 64. In the chip placing apparatus 60, the chips C are attracted to and held on the attraction surface of the first electrostatic carrier Cw1 by a Coulomb force generated by the application of the voltage.

Here, the location of the power supply 66 is not limited to the present example, and the power supply 66 may be disposed outside the second holder 64 as long as it can apply the voltage to the first electrostatic carrier Cw1 appropriately.

The communicator 67 communicates with the attraction control terminal 3 provided inside the first electrostatic carrier Cw1, and transmits a holding control signal for the chips C to the first electrostatic carrier Cw1. The attraction control terminal 3 independently applies the voltage from the power supply 66 to each of the plurality of attraction electrodes 2 based on the received holding control signal, thus controlling a holding state of each of the plurality of chips C on the holding surface independently. Further, the communication between the communicator 67 and the attraction control terminal 3 may be performed in a wired or wireless manner.

The alignment mechanism 68 is configured to align the first electrostatic carrier Cw1 held by the second holder 64 with the chip C held by the second collet 65. More specifically, the alignment mechanism 68 performs alignment between the one chip C held by the second collet 65 and an attracting/holding position for the chip C on the attraction surface of the first electrostatic carrier Cw1, that is, a position corresponding to the attraction electrode 2 within the attraction surface of the first electrostatic carrier Cw1.

Further, the alignment mechanism 68 is capable of detecting whether the chip C has been appropriately placed on the attraction surface of the first electrostatic carrier Cw1. More specifically, the alignment mechanism 68 is capable of performing alignment between the position of the chip C actually placed on the attraction surface of the first electrostatic carrier Cw1 and the position corresponding to the attraction electrode 2 within the attraction surface of the first electrostatic carrier Cw1.

The alignment mechanism 68 may include, for example, a camera and a sensor.

In the protective film forming apparatus 70, a protective film P1 (first protective film) configured to suppress contamination of the attraction surface of the first electrostatic carrier Cw1 in a subsequent process is formed on the attraction surface of the first electrostatic carrier Cw1 on which the plurality of chips C have been placed. The configuration of the protective film forming apparatus 70 is not particularly limited.

In the processing apparatus 80, the rear surface Cb side of the chip C on the attraction surface of the first electrostatic carrier Cw1, more specifically, the silicon layer Si is ground, so that the silicon layer Si is thinned and the rear surface Cb side is planarized. The configuration of the processing apparatus 80 is not particularly limited.

In the protective film removing apparatus 90, the protective film P1 remaining on the attraction surface of the first electrostatic carrier Cw1 after the grinding in the processing apparatus 80 is removed. The configuration of the protective film removing apparatus 90 is not particularly limited.

In the transferring apparatus 100, the chip C whose front surface Ca side is attracted to and held by the first electrostatic carrier Cw1 is subjected to grip changing (transferring) so that the rear surface Cb side of the chip C is attracted to and held by the second electrostatic carrier Cw2. Accordingly, the front and rear surfaces of the chip C are inverted.

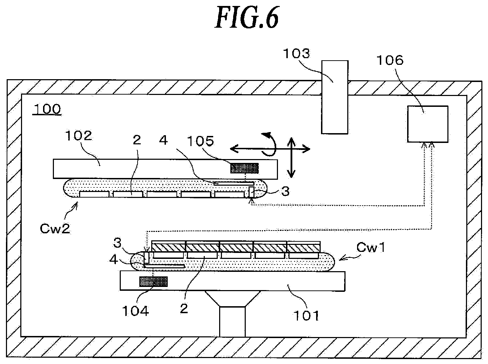

As depicted in **FIG. 6****,** the transferring apparatus 100 includes a holder 101, a transferrer 102, an alignment mechanism 103, a first power supply 104, a second power supply 105, and a communicator 106.

The holder 101 as a first transferring carrier holder has a holding surface for the first electrostatic carrier Cw1 on a top surface thereof, and configured to hold the first electrostatic carrier Cw1 transferred by the transfer device 50 such that the plurality of chips C attracted and held on the attraction surface thereof face upwards.

The transferrer 102 as a second transferring carrier holder has a holding surface for the second electrostatic carrier Cw2 on a bottom surface thereof, and configured to hold the second electrostatic carrier Cw2 transferred by the transfer device 50 such that an attraction surface of the second electrostatic carrier Cw2 for the chips C faces downwards. Further, in one example, the transferrer 102 is configured to be rotated around a horizontal axis to thereby invert the top and bottom surfaces of the chip C attracted and held thereby.

The alignment mechanism 103 is configured to align the first electrostatic carrier Cw1 held by the holder 101 with the second electrostatic carrier Cw2 held by the transferrer 102. More specifically, the alignment mechanism 103 performs alignment between the plurality of chips C held by the first electrostatic carrier Cw1 and attracting/holding positions for the chips C on the attraction surface of the second electrostatic carrier Cw2, that is, positions corresponding to the attraction electrodes 2 within the attraction surface of the second electrostatic carrier Cw2. The alignment mechanism 103 may include, by way of non-limiting example, a camera and a sensor.

In one example, the first power supply 104 is disposed inside the holder 101 and is configured to apply a negative voltage to the first electrostatic carrier Cw1 on the holder 101. In the transferring apparatus 100, by applying the negative voltage to the attraction electrode 2 of the first electrostatic carrier Cw1 in this way, the chip C on the attraction surface is separated from the first electrostatic carrier Cw1.

Further, the location of the first power supply 104 is not limited to the present example, and the first power supply 104 may be disposed outside the holder 101 as long as it is capable of appropriately applying the voltage to the first electrostatic carrier Cw1.

In one example, the second power supply 105 is disposed inside the transferrer 102, and is configured to apply a voltage to the second electrostatic carrier Cw2 on the transferrer 102. In the transferring apparatus 100, the chip C is attracted to and held on the attraction surface of the second electrostatic carrier Cw2 by a Coulomb force generated by this voltage application.

Additionally, the location of the second power supply 105 is not limited to the present example, and the second power supply 105 may be disposed outside the transferrer 102 as long as it is capable of appropriately applying the voltage to the second electrostatic carrier Cw2.

The communicator 106 communicates with the attraction control terminals 3 disposed inside the first electrostatic carrier Cw1 and the second electrostatic carrier Cw2, respectively, and transmits a holding control signal for the chips C to these electrostatic carriers Cw and Cw2. In the first electrostatic carrier Cw1, the negative voltage from the first power supply 104 is applied to the plurality of attraction electrodes 2 all at once based on the holding control signal received by the attraction control terminal 3, thus controlling the holding states of the plurality of chips C on the attraction surface. Further, in the second electrostatic carrier Cw2, the voltage from the second power supply 105 is applied to the plurality of attraction electrodes 2 all at once based on the holding control signal received by the attraction control terminal 3, thus controlling the holding states of the plurality of chips C on the attraction surface. In addition, the communication between the communicator 106 and the attraction control terminal 3 may be performed in a wired or wireless manner.

As shown in **FIG. 2****,** in each of the first electrostatic carrier Cw1 and the second electrostatic carrier Cw2, the plurality of attraction electrodes 2 are disposed so as to correspond to the bonding positions of the chips C (mounting positions of the chips C) on the chip mounting surface of the wafer W. In other words, the plurality of attraction electrodes 2 are arranged in the same layout in the first electrostatic carrier Cw1 and the second electrostatic carrier Cw2. For this reason, the transferring apparatus 100 can transfer the plurality of chips C held by the first electrostatic carrier Cw1 to the second electrostatic carrier Cw2 all at once.

Furthermore, although the plurality of chips C can be moved all together in the transferring apparatus 100 as stated above, it may sometimes be required to move or not to move only some of the chips C. In such cases, the application of the voltage to each of the plurality of attraction electrodes 2 may be independently controlled by the attraction control terminal 3 to control the holding state of each of the plurality of chips C on the attraction surface independently.

Moreover, although the first power supply 104 configured to apply the voltage to the first electrostatic carrier Cw1 and the second power supply 105 configured to apply the voltage to the second electrostatic carrier Cw2 are provided independently in the shown example, a single power supply may control the application of the voltage to both the first electrostatic carrier Cw1 and the second electrostatic carrier Cw2 if it is possible to apply the voltage to both the first electrostatic carrier Cw1 and the second electrostatic carrier Cw2 from that single power supply.

In addition, although the first electrostatic carrier Cw1 is held by the holder 101 and the second electrostatic carrier Cw2 is held by the transferrer 102 in the shown example, the second electrostatic carrier Cw2 may be held by the holder 101, and the first electrostatic carrier Cw1 may be held by the transferrer 102.

Besides, although the holder 101 is fixed to a bottom side of the transferring apparatus 100 in the shown example, the holder 101 may be fixed to a top side of the transferring apparatus 100. In other words, in the transferring apparatus 100, the first electrostatic carrier Cw1 may be held by the holder 101 such that the plurality of chips C attracted to and held on the attraction surface of the first electrostatic carrier Cw1 face downwards, and the second electrostatic carrier Cw2 may be held by the transferrer 102 such that the attraction surface for the chips C faces upwards.

In the second protective film forming apparatus 110, a protective film P2 (second protective film) is formed on the attraction surface of the second electrostatic carrier Cw2 for attracting and holding the plurality of chips C in order to suppress contamination of the attraction surface of the second electrostatic carrier Cw2 in a subsequent process. Here, the configuration of the second protective film forming apparatus 110 is not particularly limited.

Further, in the present exemplary embodiment, although the protective film forming apparatus 70 configured to form the protective film P1 and the second protective film forming apparatus 110 configured to form the protective film P2 are provided independently, the protective film P1 and the protective film P2 may be formed within one and the same apparatus. That is, in the processing system 10, either the protective film forming apparatus 70 or the second protective film forming apparatus 110 may be omitted.

In the planarizing apparatus 120, the front surface Ca of the chip C, which is a surface to be bonded to the wafer W in a subsequent process, is planarized, and the aforementioned protective film (not shown) formed on the front surface Ca is removed. Here, the configuration of the planarizing apparatus 120 is not particularly limited.

In the second protective film removing apparatus 130, the protective film P2 remaining on the attraction surface side of the second electrostatic carrier Cw2 after the planarizing process in the planarizing apparatus 120 is removed. Here, the configuration of the second protective film removing apparatus 130 is not particularly limited.

Further, in the present exemplary embodiment, although the protective film removing apparatus 90 configured to remove the protective film P1 and the second protective film removing apparatus 130 configured to remove the protective film P2 are provided independently, the protective film P1 and the protective film P2 may be removed in one and the same apparatus. That is, in the processing system 10, either the protective film removing apparatus 90 or the second protective film removing apparatus 130 may be omitted.

In the bonding apparatus 140, the plurality of chips C attracted to and held by the second electrostatic carrier Cw2 are bonded to the bonding positions on the mounting surface of the wafer W to which the chips C are to be mounted.

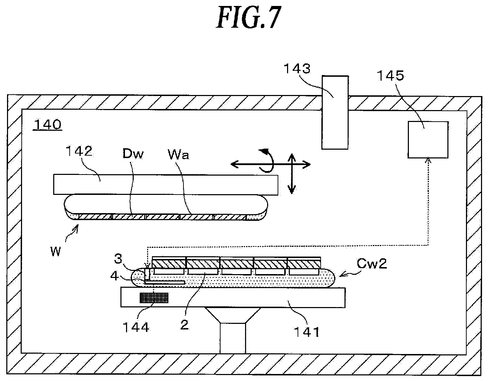

As shown in **FIG. 7****,** the bonding apparatus 140 is equipped with a holder 141, a transferrer 142, an alignment mechanism 143, a power supply 144, and a communicator 145.

The holder 141 as a bonding carrier holder has a holding surface for the second electrostatic carrier Cw2 on a top surface thereof, and is configured to hold the second electrostatic carrier Cw2 transferred by the transfer device 50 such that the plurality of chips C attracted to and held on the attraction surface face upwards.

The transferrer 142 as a substrate holder has, on a bottom surface thereof, a holding surface for the wafer W on which the chips C are to be mounted, and is configured to hold the wafer W transferred by the transfer device 50 such that the mounting surface for the chips C faces downwards. Further, in one example, the transferrer 142 is configured to be rotatable around a horizontal axis, thus allowing the top and bottom surfaces of the held wafer W to be inverted.

The alignment mechanism 143 is configured to align the second electrostatic carrier Cw2 held by the holder 141 with the wafer W held by the transferrer 142. More specifically, the alignment mechanism 143 performs alignment between the plurality of chips C attracted to and held by the second electrostatic carrier Cw2 and the bonding positions of the chips C on the mounting surface of the wafer W, that is, positions on the front surface Wa of the wafer W corresponding to the smaller sections of the device layer Dw. The alignment mechanism 143 may include, by way of non-limiting example, a camera and a sensor.

In one example, the power supply 144 is disposed inside the holder 141, and is configured to apply a negative voltage to the second electrostatic carrier Cw2 on the holder 141. In the bonding apparatus 140, by applying the negative voltage to the attraction electrode 2 of the second electrostatic carrier Cw2 in this way, the chip C on the attraction surface is separated from the second electrostatic carrier Cw2.

Further, the location of the power supply 144 is not limited to the present example, and the power supply 144 may be disposed outside the holder 141 as long as it is capable of appropriately applying the voltage to the second electrostatic carrier Cw2.

The communicator 145 communicates with the attraction control terminal 3 disposed inside the second electrostatic carrier Cw2, and is configured to transmit a holding control signal for the chips C to the second electrostatic carrier Cw2. The attraction control terminal 3 applies the voltage from the power supply 144 to each of the plurality of attraction electrodes 2 independently based on the received holding control signal, thus controlling the holding state of each of the plurality of chips C on the attraction surface independently. Here, the communication between the communicator 145 and the attraction control terminal 3 may be performed in a wired or wireless manner.

Moreover, although the second electrostatic carrier Cw2 is held by the holder 141 and the wafer W is held by the transferrer 142 in the shown example, the wafer W may be held by the holder 141, and the second electrostatic carrier Cw2 may be held by the transferrer 102. In this case, the power supply 144 may be disposed inside the transferrer 142.

In addition, although the holder 141 is fixed to a bottom side of the bonding apparatus 140 in the shown example, the holder 141 may be fixed to a top side of the bonding apparatus 140. In other words, in the bonding apparatus 140, the second electrostatic carrier Cw2 may be held by the holder 141 such that the plurality of chips C attracted to and held on its attraction surface face downwards, and the wafer W may be held by the transferrer 142 such that its mounting surface for the chips C faces upwards.

The above-described processing system 10 is equipped with a control device 150. The control device 150 is, for example, a computer equipped with a CPU and a memory, and has a program storage (not shown). The program storage stores therein a program for controlling the chip-on-wafer manufacturing process in the processing system 10. Further, the program may have been recorded on a computer-readable recording medium H, and may be installed into the control device 150 from the recording medium H. In addition, the recording medium H may be transitory or non-transitory.

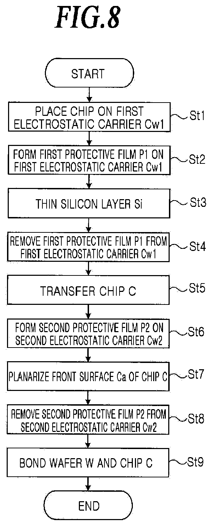

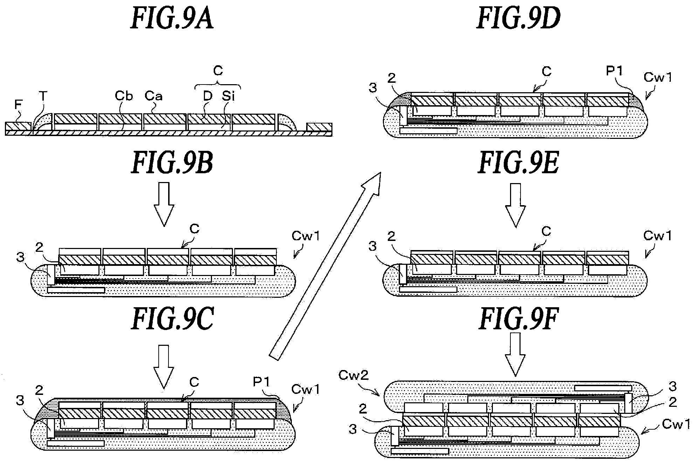

Now, the chip-on-wafer manufacturing process performed in the processing system 10 configured as described above will be explained. **FIG. 8** is a flowchart showing main processes of the chip-on-wafer manufacturing process. **FIG. 9A** to **FIG. 10F** are explanatory side views schematically illustrating some of the processes of the chip-on-wafer manufacturing process.

First, the FOUPs Ff and Fw accommodating therein the plurality of dicing frames F and the plurality of wafers W, respectively, and the FOUP Fc accommodating therein the first electrostatic carrier Cw1 and the second electrostatic carrier Cw2 are placed on the FOUP placing table 20 of the carry-in/out station 11.

As depicted in **FIG. 9A****,** the dicing frame F accommodated in the FOUP Ff has the dicing tape T fixed thereto, and this dicing tape T has the plurality of chips C attached thereto. The rear surface Cb side of each of the plurality of chips C is attached to the dicing tape T.

Further, the front surface Wa side of the wafer W accommodated in the FOUP Fw is previously subjected to a pretreatment to be bonded to the chip C described above.

Then, the dicing frame F in the FOUP Ff is taken out by the transfer device 30, and is transferred to the transition device 40. The dicing frame F sent to the transition device 40 is then transferred to the chip placing apparatus 60 by the transfer device 50. Concurrently or subsequently, the first electrostatic carrier Cw1 in the FOUP Fc is transferred to the chip placing apparatus 60.

In the chip placing apparatus 60, the chip C whose rear surface Cb side is attached to the adhesive surface of the dicing tape T is placed at the position corresponding to the attraction electrode 2 within the attraction surface of the first electrostatic carrier Cw1 such that the rear surface Cb side faces upwards, and is attracted to and held by the attraction electrode 2, as shown in **FIG. 9B** (process St1 in **FIG. 8**).

Hereinafter, an example of an operation of placing the chip C on the first electrostatic carrier Cw1 in the chip placing apparatus 60 will be described.

First, among the plurality of chips C attached to the dicing tape T, one chip C is selectively pushed up and raised from below (rear surface Cb side) by the pusher 62.

Then, the front surface Ca of the one chip C that has been pushed up is held from above by the first collet 63.

Next, the first collet 63 is rotated around the horizontal axis, thus allowing the front and rear surfaces of the chip C to be inverted. In other words, the first collet 63 is set with the chip C facing upwards.

Thereafter, the rear surface Cb of the chip C held by the first collet 63 is held from above by the second collet 65, and the holding of the front surface Ca of the chip C by the first collet 63 is released. In other words, the grip changing of the chip C is performed so that the chip C is transferred from the state where it is held by the first collet 63 into a state where it is held by the second collet 65.

Then, the second collet 65 holding the chip C is moved to the position corresponding to one attraction electrode 2 on the attraction surface of the first electrostatic carrier Cw1. The alignment of the second collet 65 and the attraction electrode 2 is appropriately performed by using the alignment mechanism 68.

Next, the voltage is applied from the power supply 66 to the one attraction electrode 2 via the attraction control terminal 3, so that the chip C is attracted to and held on the attraction surface of the first electrostatic carrier Cw1 by the generated Coulomb force. Thereafter, the holding of the rear surface Cb of the chip C by the second collet 65 is released.

Finally, by using the alignment mechanism 68, it is detected whether or not the chip C has been appropriately placed on the one attraction electrode 2. As a result of the detection, when it is determined that the chip C has been appropriately placed, an operation of placing a next chip C in the form of the dicing tape T is started. On the other hand, when it is determined that the chip C has not been properly placed, the placed chip C is re-held by the second collet 65, and the chip C is placed again on the one attraction electrode 2.

The operation of placing the chip C on the first electrostatic carrier Cw1 according to the exemplary embodiment is performed as described above. This operation of placing the chip C is performed independently and continuously for each of the plurality of chips C attached to the dicing tape T.

Further, in the above-described example, after the chip C is placed on the attraction surface of the first electrostatic carrier Cw1, the voltage is applied to the one attraction electrode 2 to attract the chip C. However, the timing for the voltage application to the attraction electrode 2 is not limited thereto. That is, the voltage may be applied to the attraction electrode 2 in advance prior to the placement of the chip C on the attraction surface, or the voltage may be applied to the attraction electrode 2 concurrently with the placement of the chip C on the attraction surface, for example.

Here, however, when the voltage is applied to the attraction electrode 2 in the state that the chip C is not placed on the attraction surface, there is a risk that particles may be attracted and attached to the attraction surface due to the generated Coulomb force. In consideration of this, it is desirable that the timing for the voltage application to the attraction electrode 2 is later than or at the same time as the placement of the chip C on the attraction surface.

Moreover, although the chips C get attracted to and held on the attraction surface of the first electrostatic carrier Cw1 one by one by controlling the application of the voltage to each of the plurality of attraction electrodes 2 independently, the application of the voltage to the plurality of attraction electrodes 2 may be controlled all at once. That is, the voltage may be applied to all the attraction electrodes 2 in advance prior to the transfer of the chips C by the collet, or the voltage may be applied to all the attraction electrodes 2 after the completion of the placement of all the chips C on the attraction surface.

As mentioned above, however, when the voltage is applied to the attraction electrode 2 on which no chip C is disposed, there is a risk that particles may adhere to the attraction surface due to the generated Coulomb force. In consideration of this, it is desirable that the voltage is applied to the attraction electrode 2 after the placement of the chips C on the attraction surface is completed. Additionally, it is more desirable to control the application of the voltage to each of the attraction electrodes 2 independently.

Subsequently, the first electrostatic carrier Cw1 holding the plurality of chips C is transferred to the protective film forming apparatus 70 by the transfer device 50. In the protective film forming apparatus 70, the protective film P1 is formed as shown in **FIG. 9C** to suppress the contamination of the attraction surface of the first electrostatic carrier Cw1 in the subsequent process in the processing apparatus 80 (process St2 in **FIG. 8**).

Further, the method of forming the protective film P1 is not particularly limited. As an example, the protective film forming apparatus 70 may adopt a so-called spin-on coating method in which a liquid coating material is supplied onto the attraction surface of the first electrostatic carrier Cw1 while rotating the first electrostatic carrier Cw1.

Next, the first electrostatic carrier Cw1 is transferred to the processing apparatus 80 by the transfer device 50. In the processing apparatus 80, the rear surface Cb side of the chip C attracted to and held by the first electrostatic carrier Cw1 is ground to thin the silicon layer Si of the chip C and planarize the rear surface Cb side, as illustrated in **FIG. 9D** (process St3 in **FIG. 8**).

Thereafter, the first electrostatic carrier Cw1 is transferred to the protective film removing apparatus 90 by the transfer device 50. In the protective film removing apparatus 90, the protective film P1 remaining on the attraction surface of the first electrostatic carrier Cw1 after the thinning of the silicon layer Si is removed, as shown in **FIG. 9E** (process St4 in **FIG. 8**).

Here, the method of removing the protective film P1 is not particularly limited. As an example, the protective film removing apparatus 90 may remove the protective film P1 by so called spin etching in which a chemical liquid for etching is supplied to the attraction surface of the first electrostatic carrier Cw1 while rotating the first electrostatic carrier Cw1.

Thereafter, the first electrostatic carrier Cw1 is transferred to the transferring apparatus 100 by the transfer device 50. Also, concurrently with this transfer of the first electrostatic carrier Cw1 or subsequently thereafter, the second electrostatic carrier Cw2 in the FOUP Fc is transferred to the transferring apparatus 100.

In the transferring apparatus 100, the plurality of chips C with their front surface Ca sides thereof attracted to and held by the first electrostatic carrier Cw1 are transferred into a state in which their rear surface Cb sides are attracted to and held by the second electrostatic carrier Cw2, as illustrated in **FIG. 9F****.** In other words, the grip changing operation for the chips C is performed to transfer the chips C from the first electrostatic carrier Cw1 to the second electrostatic carrier Cw2, whereby the front and rear surfaces (holding surfaces) of the chips C are inverted (process St5 in **FIG. 8**).

Hereinafter, an example of the grip switching operation for the chips C in the transferring apparatus 100 will be described.

First, the first electrostatic carrier Cw1, which is attracting and holding the plurality of chips C, is placed on the holder 101 such that the attraction surface thereof faces upwards, that is, such that the plurality of chips C face upwards.

Then, the transferrer 102 holding the second electrostatic carrier Cw2 is placed above the first electrostatic carrier Cw1. The second electrostatic carrier Cw2 is held by the transferrer 102 with its attraction surface for the chips C facing downwards. At this time, the second electrostatic carrier Cw2 held by the transferrer 102 is aligned by the alignment mechanism 103 such that the positions of the respective attraction electrodes 2 on the attraction surface of the second electrostatic carrier Cw2 correspond to the positions of the plurality of chips C on the first electrostatic carrier Cw1, respectively.

Next, the voltage is applied from the second power supply 105 to the plurality of attraction electrodes 2 of the second electrostatic carrier Cw2 all at once via the attraction control terminal 3, so that the rear surface Cb side of each chip C is attracted to and held on the attraction surface of the second electrostatic carrier Cw2 by the Coulomb force generated as a result of the voltage application. Subsequently, the negative voltage is applied from the first power supply 104 to the plurality of attraction electrodes 2 of the first electrostatic carrier Cw1 all at once via the attraction control terminal 3, so that the front surface Ca side of each chip C is separated from the first electrostatic carrier Cw1.

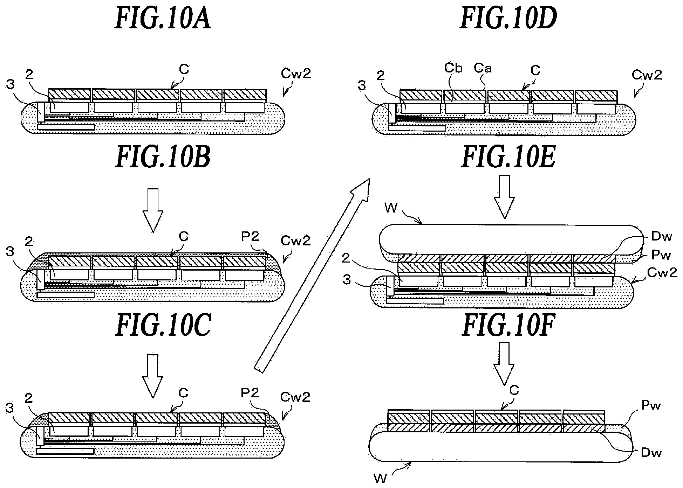

Finally, as depicted in **FIG. 10A****,** the transferrer 102 is rotated around the horizontal axis, thereby inverting the front and rear surfaces of the second electrostatic carrier Cw2. In other words, the plurality of chips C are turned to face upwards.

The grip switching operation for the chips C according to the exemplary embodiment is performed as described above. Further, the first electrostatic carrier Cw1 after being subjected to the separation of the chips C is transferred to the transition device 40 by the transfer device 50, and is transferred back into the FOUP Fc ono the FOUP placing table 20 by the transfer device 30.

In addition, in the above-described example, the grip switching of the plurality of chips C from the attraction surface of the first electrostatic carrier Cw1 to the attraction surface of the second electrostatic carrier Cw2 is performed all at once. As stated above, however, by independently controlling the application of the voltage to each of the plurality of attraction electrodes 2, the grip switching of at least some of the plurality of chips C may be controlled independently.

Moreover, the first electrostatic carrier Cw1 attracting and holding the plurality of chips C may be held such that its attraction surface faces downwards, that is, such that the plurality of chips C face downwards, and the second electrostatic carrier Cw2 may be disposed below the first electrostatic carrier Cw1. In other words, the vertical arrangement of the first electrostatic carrier Cw1 and the second electrostatic carrier Cw2 is not limited to the shown example, and they may be held and transferred with their vertical positions reversed.

Next, the second electrostatic carrier Cw2 attracting and holding the plurality of chips C is transferred to the second protective film forming apparatus 110 by the transfer device 50.

In the second protective film forming apparatus 110, the protective film P2 is formed as shown in **FIG. 10B** to suppress contamination of the attraction surface of the second electrostatic carrier Cw2 in the subsequent process in the planarizing apparatus 120 (process St6 in **FIG. 8**).

Here, although the method of forming the protective film P2 is not particularly limited, the protective film P2 may be formed by the same method as the protective film P1, for example. That is, in one example, the second protective film forming apparatus 110 may form the protective film P2 by so-called spin-on coating method in which a liquid coating material is supplied onto the attraction surface of the second electrostatic carrier Cw2 while rotating the second electrostatic carrier Cw2.

Subsequently, the second electrostatic carrier Cw2 is transferred to the planarizing apparatus 120 by the transfer device 50.

In the planarizing apparatus 120, the front surface Ca side of the chip C to be bonded to the wafer W in the subsequent process is polished and planarized, as illustrated in **FIG. 10C** (process St7 in **FIG. 8**). Also, at this time, the aforementioned protective film (not shown) formed on the front surface Ca of the chip C is removed.

Here, although the method of planarizing the front surface Ca of the chip C is not particularly limited, the planarizing apparatus 120 may planarize the front surface Ca of the chip C by a CMP (Chemical Mechanical Polishing) treatment.

Thereafter, the second electrostatic carrier Cw2 is transferred to the second protective film removing apparatus 130 by the transfer device 50.

In the second protective film removing apparatus 130, the protective film P2 remaining on the attraction surface of the second electrostatic carrier Cw2 after the planarization process in the planarizing apparatus 120 is removed, as shown in **FIG. 10D** (process St8 in **FIG. 8****).**

Here, although the method of removing the protective film P2 is not particularly limited, the protective film P2 can be removed by the same method as the protective film P1, for example. That is, in one example, the second protective film removing apparatus 130 may remove the protective film P2 by so-called spin etching in which a chemical liquid for etching is supplied to the attraction surface of the second electrostatic carrier Cw2.

Next, the second electrostatic carrier Cw2 is transferred to the bonding apparatus 140 by the transfer device 50. Also, concurrently with this transfer of the second electrostatic carrier Cw2 or subsequently thereafter, the wafer W in the FOUP Fw is transferred to the bonding apparatus 140.

In the bonding apparatus 140, as illustrated in **FIG. 10E****,** the plurality of chips C on the second electrostatic carrier Cw2 and the mounting surface (preprocessed front surface Wa) of the wafer W on which the chips C are to be mounted are overlapped and pressed from a vertical direction, so that the chips C are bonded to the wafer W (so-called fusion bonding) (process St9 of **FIG. 8**).

Hereinafter, an example of a bonding operation of bonding the chips C to the wafer W in the bonding apparatus 140 will be described.

First, the second electrostatic carrier Cw2, which is attracting and holding the plurality of chips C, is placed on the holder 141 with its attraction surface facing upwards, that is, with the plurality of chips C facing upwards.

Then, the transferrer 142 holding the wafer W is placed above the second electrostatic carrier Cw2. The wafer W is held by the transferrer 142 with its front surface Wa, which is the preprocessed mounting surface for the chips C, facing downwards. At this time, the wafer W held by the transferrer 142 is aligned by the alignment mechanism 143 such that the positions of the smaller sections of the device layer Dw on the mounting surface of the wafer W correspond to the positions of the plurality of chips C on the second electrostatic carrier Cw2, respectively.

Next, the chips C on the second electrostatic carrier Cw2 held by the holder 141 and the device layer Dw on the wafer W held by the transferrer 142 are pressed from the vertical direction, thus allowing the chips C and the device layer Dw to be bonded to each other.

Thereafter, the negative voltage is applied from the power supply 144 to the plurality of attraction electrodes 2 of the second electrostatic carrier Cw2 all at once via the attraction control terminal 3, so that the rear surface Cb sides of the chips C are separated from the second electrostatic carrier Cw2.

Finally, as shown in **FIG. 10F****,** the transferrer 142 is rotated around a horizontal axis, whereby the front and rear surfaces of the wafer W are inverted. In other words, the mounting surface of the wafer W on which the plurality of chips C are bonded is made to face upwards.

The bonding operation of bonding the chips C to the wafer W according to the exemplary embodiment is performed as described above.

Further, the second electrostatic carrier Cw2 attracting and holding the plurality of chips C as described above may be held such that its attraction surface faces downwards, that is, such that the plurality of chips C face downwards, and the wafer W may be disposed below the second electrostatic carrier Cw2. In other words, the vertical arrangement of the second electrostatic carrier Cw2 and the wafer W is not limited to the shown example, and they may be held and transferred with their vertical positions reversed.

Afterwards, the wafer W on which the chips C are mounted is transferred to the transition device 40 by the transfer device 50, and is then transferred to the FOUP Fw of the FOUP placing table 20 by the transfer device 30.

Likewise, the second electrostatic carrier Cw2 from which the chips C have been separated is transferred to the transition device 40 by the transfer device 50, and is then transferred to the FOUP Fc of the FOUP placing table 20 by the transfer device 30. In this way, the series of chip-on-wafer manufacturing processes in the processing system 10 are completed.

According to the above-described exemplary embodiment, in the series of chip-on-wafer manufacturing processes, instead of transferring and processing the chips C to be mounted on the wafer W by temporarily bonding (temporarily placing) the chips C on the carrier wafer as in the prior art, the chips C are electrostatically attracted to the electrostatic carrier Cw to be transferred and processed.

In the conventional chip-on-wafer manufacturing process, to temporarily place the chips C on the carrier wafer, a series of treatments including the surface activation and the hydrophilization need to be performed on each of the plurality of chips C as described above. Thus, a great amount of cost and time is required for the temporary placement of the chips C on the carrier wafer.

Further, a so-called debonding processing is required when separating the temporarily placed chips C from the carrier wafer, resulting in the great amount of cost and time for the separation of the chips C from the carrier wafer as well.

In the electrostatic carrier Cw used instead of the carrier wafer in the present exemplary embodiment, however, the attraction/holding of the chips C on the attraction surface and the separation of the chips C from the attraction surface can be controlled simply by controlling the application of the voltage to the electrostatic carrier Cw. Thus, as compared to the conventional method, the cost and time required for the chip-on-wafer manufacturing process can be significantly reduced.

Further, according to the present exemplary embodiment, when attracting and holding the chips C on the electrostatic carrier Cw and separating the chips C from the electrostatic carrier Cw as stated above, there is no need to perform a series of treatments including the surface activation and the hydrophilization and the debonding processing as in the prior art. Accordingly, the attraction surface of the electrostatic carrier Cw is not consumed in the attraction/holding and separation of the chips C, and there is no need to replace the carrier wafer as in the prior art. Thus, the same electrostatic carrier Cw can be reused repeatedly in the chip-on-wafer manufacturing process.

Further, in the electrostatic carrier Cw according to the present exemplary embodiment, the attraction electrodes 2 for attracting and holding the chips C are arranged within the attraction surface while each having a size corresponding to the size of the chip C to be held, as shown in **FIG. 2****.** Accordingly, it is possible to independently control the application of the voltage to each of the plurality of attraction electrodes 2 via the attraction control terminal 3, and, as a result, the attraction state of each of the plurality of chips C can be controlled individually. That is, even if a problem occurs in only some of the chips C on the attraction surface, it is easy to separate only the defective chips C from the electrostatic carrier Cw independently.

Moreover, the electrostatic carrier Cw according to the present exemplary embodiment is configured to have substantially the same shape as the wafer W on which the chips C are to be mounted, as described above. In other words, the electrostatic carrier Cw according to the present exemplary embodiment substantially has a wafer shape. This makes it possible to handle the electrostatic carrier Cw within the processing system 10 in the same manner as the carrier wafer used in the conventional chip-on-wafer manufacturing process. That is, the technique according to the present disclosure can be applied to the existing processing system 10 without major system changes.

In addition, by configuring the electrostatic carrier Cw to have substantially the same shape as the wafer W on which the chips C are to be mounted, the alignment between the wafer W and the electrostatic carrier Cw, that is, the alignment between the device layer Dw and the chips C within the bonding apparatus 140 can be easily performed by using the conventional method.

Furthermore, according to the present exemplary embodiment, in the electrostatic carrier Cw, the terminal (attraction control terminal 3) for controlling the bonding and the separation is disposed on the same plane as the attraction surface for the chips C.

As stated above, the attraction control terminal 3 of the electrostatic carrier Cw transmits and receives the holding control signals to and from the communicators belonging to the various kinds of processing apparatuses in a wired or wireless manner.

At this time, especially when the transmission and reception of the information to and from the communicator is performed by wire, if the attraction control terminal 3 is disposed on a surface (a surface held by the holder) of the electrostatic carrier Cw opposite to the attraction surface for the chips C, a groove or hole for wiring connection is required in the holder for holding the electrostatic carrier Cw. Thus, a large-scale modification of the processing apparatus is needed. In addition, when the groove or hole for the wiring connection is formed in the holder in this way, there is a risk that the attraction and holding of the electrostatic carrier Cw by the holder may become difficult.

In this regard, by disposing the attraction control terminal 3 on the same surface as the attraction surface for the chips C as stated above, the technique according to the present disclosure can be applied only by slightly modifying the existing processing apparatus, and, also, the attraction and holding of the electrostatic carrier Cw by the holder can be appropriately carried out.

However, it should be noted that the structure of the electrostatic carrier Cw is not limited to the example shown in **FIG. 2****,** and the attraction control terminal 3 may be disposed on the holding surface side of the electrostatic carrier Cw held by the holder, or on a lateral side (near a radially outer end) thereof.

In addition, in the above-described example, although the attraction control terminal 3 is disposed inside the electrostatic carrier Cw, the terminal for controlling the application of the attraction voltage to the attraction electrode 2 may be located outside the electrostatic carrier Cw, for example, inside the holder.

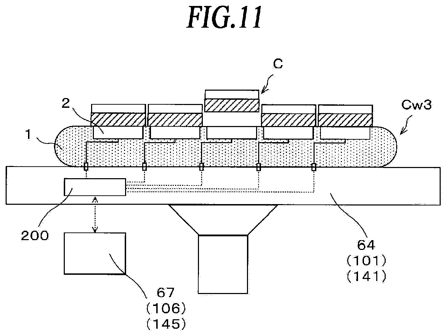

To elaborate, as shown in **FIG. 11****,** an attraction controller 200 may be disposed inside the holders (the second holder 64, and the holders 101 and 104) belonging to the various types of processing apparatuses, and a terminal disposed on a surface of a third electrostatic carrier Cw3 opposite to an attraction surface thereof, that is, on a surface in contact with the holder may be connected to a terminal disposed on a top surface side of the holder to transceive a holding control signal.

Further, as described above, the attraction and holding of the chip C by the second electrostatic carrier Cw2 in the transferring apparatus 100, and the separation of the chip C from the second electrostatic carrier Cw2 in the bonding apparatus 140 can be performed on the plurality of chips C all at once. In other words, unlike the attraction and holding of the chips C by the first electrostatic carrier Cw1 in the chip placing apparatus 60, the attraction/holding and the separation of at least some of the plurality of chips C do not necessarily need to be performed independently in the second electrostatic carrier Cw2. In view of this, the second electrostatic carrier Cw2 does not need to be configured such that the application of voltage to each of the plurality of attraction electrodes 2 can be controlled independently.

Furthermore, in the above-described exemplary embodiment, after the grinding (processes St2 to St4) of the rear surface Cb side of the chip C is performed by holding the front surface Ca side of the chip C by the first electrostatic carrier Cw1, the planarization (processes St6 to St8) of the front surface Ca side of the chip C is performed by holding the rear surface Cb side of the chip C by the second electrostatic carrier Cw2. However, the order of the processes in the processing system 10 is not limited thereto. That is, as an example, after the planarization (processes St6 to St8) of the front surface Ca side of the chip C is performed by holding the rear surface Cb side of the chip C by the first electrostatic carrier Cw1, the grinding (processes St2 to St4) of the rear surface Cb side of the chip C may be performed by holding the front surface Ca side of the chip C by the second electrostatic carrier Cw2.

In this case, however, since the front surface Ca side of the chip C is bonded to the wafer W, the chip C needs to be inverted once more prior to the bonding process (process St9) in the bonding apparatus 140. Taking this into consideration, it is desirable that the grinding (process St3) of the rear surface Cb side is performed prior to the planarization (process St7) of the front surface Ca side.

Furthermore, as stated above, in the planarization of the front surface Ca in the process St7, the non-illustrated protective film formed on the front surface Ca is removed. For this reason, if the protective film is removed as a result of performing the planarization (process St7) of the front surface Ca side prior to the grinding (process St3) of the rear surface Cb side, there is a risk that the front surface Ca may be damaged when the front surface Ca is held by the second electrostatic carrier Cw2. Taking this into account, it is desirable that the grinding (process St3) of the rear surface Cb side is performed prior to the planarization (process St7) of the front surface Ca side.

It should be noted that the above-described exemplary embodiment is illustrative in all aspects and is not anyway limiting. The above-described exemplary embodiment may be omitted, replaced and modified in various ways without departing from the scope and the spirit of claims.

For example, in the above-described exemplary embodiment, the chip placing apparatus 60, the transferring apparatus 100, and the bonding apparatus 140 are disposed in the same processing system 10. However, these chip placing apparatus 60, transferring apparatus 100 and bonding apparatus 140 may be respectively disposed in different processing systems. In other words, a first processing system for placing the chip C on the dicing frame F on the first electrostatic carrier Cw1, a second processing system for transferring the chip C from the first electrostatic carrier Cw1 to the second electrostatic carrier Cw2, and a third processing system for bonding the chip C on the second electrostatic carrier Cw2 onto the wafer W may be configured independently.

### EXPLANATION OF CODES

10: Processing system
60: Chip placing apparatus
64: Second holder
66: Power supply
C: Chip
Cw1: First electrostatic carrier
W: Wafer

## Claims

1. A processing system configured to process multiple chips, comprising:
a chip placing apparatus configured to pick the chip up and dispose on an attraction surface of a first electrostatic carrier,
wherein the chip placing apparatus comprises:
a placement carrier holder configured to hold the first electrostatic carrier; and
a power supply configured to apply a voltage to the first electrostatic carrier held by the placement carrier holder.

2. The processing system of Claim 1,
wherein the chip placing apparatus comprises a communicator configured to transmit a holding control signal for controlling a holding state of each of the multiple chips independently to the first electrostatic carrier.

3. The processing system of Claim 1 or 2, further comprising:
a protective film forming apparatus configured to form a first protective film on an attraction surface side of the first electrostatic carrier holding the multiple chips;
a processing apparatus configured to grind a non-holding surface side of each of the multiple chips that is not held by the first electrostatic carrier; and
a protective film removing apparatus configured to remove the first protective film remaining on the attraction surface side of the first electrostatic carrier after the non-holding surface side is ground.

4. The processing system of any one of Claims 1 to 3, further comprising:
a transferring apparatus configured to transfer the chip between the first electrostatic carrier and a second electrostatic carrier,
wherein the transferring apparatus comprises:
a first transferring carrier holder configured to hold the first electrostatic carrier;
a first power supply configured to apply a voltage to the first electrostatic carrier held by the first transferring carrier holder;
a second transferring carrier holder configured to hold the second electrostatic carrier such that the second electrostatic carrier faces the first electrostatic carrier held by the first transferring carrier holder; and
a second power supply configured to apply a voltage to the second electrostatic carrier held by the second transferring carrier holder.

5. The processing system of Claim 4, further comprising:
a second protective film forming apparatus configured to form a second protective film on an attraction surface side of the second electrostatic carrier holding the multiple chips;
a planarizing apparatus configured to planarize a non-bonding surface side of each of the multiple chips that is not held by the second electrostatic carrier; and
a second protective film removing apparatus configured to remove the second protective film remaining on the attraction surface side of the second electrostatic carrier after the non-bonding surface side is planarized.

6. The processing system of Claim 4 or 5, further comprising:
a bonding apparatus configured to mount the chip held by the second electrostatic carrier on a substrate,
wherein the bonding apparatus comprises:
a bonding carrier holder configured to hold the second electrostatic carrier;
a power supply configured to apply a voltage to the second electrostatic carrier held by the bonding carrier holder; and
a substrate holder configured to hold a substrate, on which the chip is to be mounted, such that the substrate faces the second electrostatic carrier held by the bonding carrier holder.

7. The processing system of Claim 6,
wherein at least one of the transferring apparatus or the bonding apparatus comprises a communicator configured to transmit a holding control signal for controlling a holding state of each of the multiple chips independently to the second electrostatic carrier.

8. A processing system configured to process a chip, comprising:
a first transferring carrier holder configured to hold a first electrostatic carrier;
a first power supply configured to apply a voltage to the first electrostatic carrier held by the first transferring carrier holder;
a second transferring carrier holder configured to hold a second electrostatic carrier such that the second electrostatic carrier faces the first electrostatic carrier held by the first transferring carrier holder; and
a second power supply configured to apply a voltage to the second electrostatic carrier held by the second transferring carrier holder.

9. A processing system configured to process a chip, comprising:
a bonding carrier holder configured to hold an electrostatic carrier;
a power supply configured to apply a voltage to the electrostatic carrier held by the bonding carrier holder; and
a substrate holder configured to hold a substrate, on which the chip is to be mounted, such that the substrate faces the electrostatic carrier held by the bonding carrier holder.

10. An electrostatic carrier configured to hold and transfer multiple chips, the electrostatic carrier comprising:
a main body having electrical insulation property;
multiple attraction electrodes disposed inside the main body, and arranged to respectively correspond to the multiple chips; and
a control terminal disposed inside the main body, and configured to control application of a voltage to each of the multiple attraction electrodes independently,
wherein the multiple chips are attracted to and held on an attraction surface of the electrostatic carrier by an electrostatic force generated by the application of the voltage to each of the multiple attraction electrodes.

11. The electrostatic carrier of Claim 10,
wherein the control terminal is disposed on an attraction surface side of the chip.

12. The electrostatic carrier of Claim 10 or 11,
wherein the multiple attraction electrodes are disposed, when viewed from above, to correspond to a mounting position of the chip on a mounting surface of a substrate, on which the multiple chips are to be mounted.

13. A processing method of processing multiple chips, comprising:
arranging the multiple chips on an attraction surface of a first electrostatic carrier; and
arranging the multiple chips, which are held by the first electrostatic carrier, on an attraction surface of a second electrostatic carrier,
wherein the second electrostatic carrier attracts and holds a surface of each of the multiple chips opposite to a surface thereof attracted to and held by the first electrostatic carrier.

14. The processing method of Claim 13,
wherein the multiple chips are independently disposed on the attraction surface of the first electrostatic carrier one by one, and
the first electrostatic carrier controls application of a power to each of multiple attraction electrodes, which are disposed to respectively correspond to the multiple chips, to control a holding state of each of the multiple chips independently.

15. The processing method of Claim 13 or 14, further comprising:
forming a first protective film on an attraction surface side of the first electrostatic carrier holding the multiple chips;
grinding a non-holding surface side of each of the multiple chips that is not held by the first electrostatic carrier; and
removing the first protective film remaining on the attraction surface side of the first electrostatic carrier after the non-holding surface side is ground.

16. The processing method of any one of Claims 13 to 15, further comprising:
transferring the multiple chips held by the second electrostatic carrier onto a mounting surface of a substrate on which the chips are to be mounted, and bonding the chips to the mounting surface.

17. The processing method of Claim 16, further comprising:
forming a second protective film on an attraction surface side of the second electrostatic carrier holding the multiple chips;
planarizing a non-holding surface side of each of the multiple chips that is not held by the second electrostatic carrier; and
removing the second protective film remaining on the attraction surface side of the second electrostatic carrier after the non-holding surface side is planarized.

18. A processing method of processing multiple chips, comprising:
transferring the multiple chips held by an electrostatic carrier onto a mounting surface of a substrate on which the multiple chips are to be mounted, and bonding the multiple chips to the mounting surface; and
separating the multiple chips from the electrostatic carrier by applying a negative voltage to the electrostatic carrier.
